# EUROPEAN PATENT APPLICATION

(11) **EP 4 604 679 A1**
(43) Date of publication of application: **20.08.2025**
(21) Application number: 24157804.6
(22) Date of filing: 15.02.2024
(51) Int. Cl.: H05K 1/02, H05K 1/14, H05K 1/11, H05K 3/36, B60L 58/00, H01M 50/519

(54) **METHOD FOR ELECTRICALLY CONNECTING ELECTRONIC COMPONENTS OF A BATTERY SYSTEM AND BATTERY SYSTEM**

(71) Applicant: Samsung SDI Co., Ltd., Yongin-si, Gyeonggi-do 17084 (KR)
(72) Inventor: Gombats, Ilya, 8052 Graz (AT)
(74) Representative: Gulde & Partner

(57) **Abstract**

The present disclosure refers to a method for electrically connecting a first electronic component (14) of a battery system (100) with a second electronic component (10) of the battery system (100), the first electronic component (14) having a flexible printed circuit, FPC, (20) wherein the FPC (20) comprises one or more pins (29) formed by folding a connection portion (24) of the FPC (20), one or more conductive strips (26) being disposed on an outer surface of the folded connection portion (24), the second electronic (10) component having a printed circuit board, PCB, (30) wherein the PCB (30) comprises one or more through-holes (32) each adapted to receive one of the pins (29) of the FPC (20), the through-holes (32) extending through the PCB (30) from a first side of the PCB (30) to a second side of the PCB (30), wherein at each of the through-holes (32) an electrically conductive plating (34) is disposed at the second side of the PCB (30) adjacent to the through-hole (32), the method comprising the steps of: a) attaching the FPC (20) to the first side of the PCB (30) such that each of the pins (29) of the FPC (20) is received by one of the through-holes (32) of the PCB (30), b) soldering each of the pins (29) of the FPC (20) to the respective conductive plating (34) of the PCB (30) at the second side of the PCB (30) to electrically interconnect the FPC (20) and the PCB (30).

## Description

### Field of the Disclosure

The present disclosure relates to a method for electrically connecting a first electronic component of a battery system with a second electronic component of the battery system. Also, the present disclosure relates to a respective battery system and to an electric vehicle including such a battery system.

### Technological Background

Recently, vehicles for transportation of goods and peoples have been developed that use electric power as a source for motion. Such an electric vehicle is an automobile that is propelled permanently or temporarily by an electric motor, using energy stored in rechargeable batteries. An electric vehicle may be solely powered by batteries (Battery Electric Vehicle BEV) or may include a combination of an electric motor and, for example, a conventional combustion engine (Plugin Hybrid Electric Vehicle PHEV). BEVs and PHEVs use high-capacity rechargeable batteries, which are designed to give power for propulsion over sustained periods of time.

Generally, a rechargeable (or secondary) battery cell includes an electrode assembly including a positive electrode, a negative electrode, and a separator interposed between the electrodes. A solid or liquid electrolyte allows movement of ions during charging and discharging of the battery cell. The electrode assembly is located in a casing and electrode terminals, which are positioned on the outside of the casing, establish an electrically conductive connection to the electrodes. The shape of the casing may be, for example, cylindrical or rectangular.

A battery module is formed of a plurality of battery cells connected in series or in parallel. That is, the battery module is formed by interconnecting the electrode terminals of the plurality of battery cells depending on a required amount of power and in order to realize a high-power rechargeable battery.

Battery modules can be constructed in either a block design or in a modular design. In the block design each battery cell is coupled to a common current collector structure and a common battery management system and the unit thereof is arranged in a housing. In the modular design, pluralities of battery cells are connected together to form submodules and several submodules are connected together to form the battery module. In automotive applications, battery systems generally include a plurality of battery modules connected in series for providing a desired voltage.

A battery pack is a set of any number of (for example identical) battery modules or single battery cells. The battery modules, respectively battery cells, may be configured in a series, parallel or a mixture of both to deliver the desired voltage, capacity, and/or power density. Components of a battery pack include the individual battery modules, and the interconnects, which provide electrical conductivity between the battery modules.

A battery system may also include a battery management system (BMS), which is any suitable electronic system that is configured to manage the rechargeable battery cell, battery module, and battery pack, such as by protecting the batteries from operating outside their safe operating area, monitoring their states, calculating secondary data, reporting that data, controlling its environment, authenticating it and/or balancing it. For example, the BMS may monitor the state of the battery cell as represented by voltage (e.g., a total voltage of the battery pack or battery modules, and/or voltages of individual battery cells), temperature (e.g., an average temperature of the battery pack or battery modules, coolant intake temperature, coolant output temperature, and/or temperatures of individual battery cells), coolant flow (e.g., flow rate and/or cooling liquid pressure), and current. Additionally, the BMS may calculate values based on the above parameters, such as minimum and maximum cell voltage, state of charge (SOC) or depth of discharge (DOD) to indicate the charge level of the battery cell, state of health (SOH; a variously-defined measurement of the remaining capacity of the battery cell as % of the original capacity), state of power (SOP; the amount of power available for a defined time interval given the current power usage, temperature and other conditions), state of safety (SOS), maximum charge current as a charge current limit (CCL), maximum discharge current as a discharge current limit (DCL), and internal impedance of a cell (to determine open circuit voltage).

The BMS may be centralized such that a single controller is connected to the battery cells through a multitude of wires. In other examples, the BMS may be also distributed, with a BMS board is installed at each cell, with just a single communication cable between the battery cell and a controller. In yet other examples, the BMS may have a modular construction including a few controllers, each handling a certain number of cells, while communicating between the controllers. Centralized BMSs are most economical, but are least expandable, and are plagued by a multitude of wires. Distributed BMSs are the most expensive, but are simplest to install, and offer the cleanest assembly. Modular BMSs provide a compromise of the features and problems of the other two topologies.

The BMS may protect the battery pack from operating outside its safe operating area. Operation outside the safe operating area may be indicated by over-current, over-voltage (during charging), over-temperature, under-temperature, over-pressure, and ground fault or leakage current detection. The BMS may prevent the battery from operating outside its safe operating parameter by including an internal switch (e.g., a relay or solid-state device) that opens if the battery is operated outside its safe operating parameters, requesting the devices to which the battery is connected to reduce or even terminate using the battery, and actively controlling the environment, such as through heaters, fans, air conditioning or liquid cooling.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, SoC, potential electrical performance, charging ability and internal resistance as well as actual or predicted power demands or surpluses of the consumers. Therefore, battery systems usually comprise the above-mentioned BMS for obtaining and processing such information on system level and possibly further a plurality of battery module managers, BMMs, which are part of the system's battery modules and obtain and process relevant information on module level. That is, the BMS usually measures the system voltage, the system current, the local temperature at different places inside the system housing, and the insulation resistance between live components and the system housing. Additionally, the BMMs usually measure the individual cell voltages and temperatures of the battery cells in a battery module.

Thus, the BMS is provided for managing the battery pack, such as by protecting the battery from operating outside its safe operating area, monitoring its state, calculating secondary data, reporting that data, controlling its environment, authenticating it and/or balancing it.

Electronic components of a battery system need to be electrically interconnected to perform their respective functions. For example, a control unit performing the functions of the BMS needs to be electrically connected to the battery pack in order to be able to monitor the battery cells therein and to perform the further functions explained above. Electronic components of a battery system may be electrically connected via electric elements, such as a flexible printed circuit (FPC) and a printed circuit board (PCB), which may be attached to one another in a variety of ways.

For example, an FPC and a PCB may be interconnected by a plug connector attached to an end of the FPC, the plug connector being plugged onto a corresponding plug socket of the PCB. While this type of connection between the FPC and the PCB is visually inspectable, i.e. whether the connection is correctly achieved can be determined by the (naked) eye, such a plug connector is relatively expensive. Also, mechanical issues may arise.

Alternatively, an FPC and a PCB may be interconnected by hot bar soldering, wherein conductive stripes of the FPC are directly soldered onto corresponding plating portions on the PCB. This process is relatively slow and prone to error because it is difficult to precisely position the FPC and the PCB relative to one another and to keep the FPC and the PCB in the required position for the whole duration of the soldering process. Also, electrical contact elements of the FPC and the PCB may be directly connected via crimping contacts which is, however, a complex and error-prone procedure.

It is thus an object of the present invention to provide a method for electrically connecting a first electronic component of a battery system with a second electronic component of the battery system, and to provide a respective battery system which overcome these problems, which may allow for a low-cost, fast and reliable electrical connection of electronic components.

### Summary of Invention

The invention is defined by the appended set of claims. The description that follows is subjected to this limitation. Any disclosure lying outside the scope of said claims is only intended for illustrative as well as comparative purposes.

According to one aspect of the present disclosure, a method for electrically connecting a first electronic component of a battery system with a second electronic component of the battery system is provided, the first electronic component having a flexible printed circuit, FPC, wherein the FPC includes one or more pins formed by folding a connection portion of the FPC, one or more conductive strips being disposed on an outer surface of the folded connection portion, the second electronic component having a printed circuit board, PCB, wherein the PCB includes one or more through-holes each adapted to receive one of the pins of the FPC, the through-holes extending through the PCB from a first side of the PCB to a second side of the PCB, wherein at each of the through-holes an electrically conductive plating is disposed at the second side of the PCB adjacent to the through-hole, the method including the steps of: a) attaching the FPC to the first side of the PCB such that each of the pins of the FPC is received by one of the through-holes of the PCB, b) soldering each of the pins of the FPC to the respective conductive plating of the PCB at the second side of the PCB to electrically interconnect the FPC and the PCB.

According to another aspect of the present disclosure, a battery system includes a plurality of battery cells, a first electronic component includes a flexible printed circuit, FPC, the FPC including one or more pins formed by folding a connection portion of the FPC, and a second electronic component electrically connected to the first electronic component, wherein the second electronic component includes a printed circuit board, PCB having one or more through-holes each adapted to receive one of the pins of the FPC, and wherein the connection portion has at least one slot located between the pins.

Further aspects of the present disclosure could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a schematic side view of a battery system according to an embodiment.
- Fig. 2: illustrates a schematic top section of an FPC of the battery system of Fig. 1.
- Fig. 3: illustrates a schematic perspective view of a PCB of the battery system of Fig. 1.
- Fig. 4: illustrates schematically the FPC of Fig. 1 with its connection portions being folded to a U-shape, wherein Fig. 4a shows the FPC in a top view and Fig. 4b shows the FPC in a perspective view.
- Fig. 5: illustrates a schematic perspective view of the FPC of Fig. 4 and of the PCB of Fig. 3 being in an interconnected state.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

It will also be understood that when a film, a region, or an element is referred to as being "above" or "on" another film, region, or element, it can be directly on the other film, region, or element, or intervening films, regions, or elements may also be present.

Herein, the terms "upper" and "lower" are defined according to the z-axis. For example, the upper cover is positioned at the upper part of the z-axis, whereas the lower cover is positioned at the lower part thereof. In the drawings, the sizes of elements may be exaggerated for clarity. For example, in the drawings, the size or thickness of each element may be arbitrarily shown for illustrative purposes, and thus the embodiments of the present disclosure should not be construed as being limited thereto.

In the following description of embodiments of the present disclosure, the terms of a singular form may include plural forms unless the context clearly indicates otherwise.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

### General Concept

According to the present disclosure, a method is provided for electrically connecting a first electronic component of a battery system with a second electronic component of the battery system. Also, a battery system is provided wherein the first electronic component and the second electronic component have been electrically interconnected via the method of the present disclosure. Thus, the method of the present disclosure is adapted to produce the battery system of the present disclosure. In the following, both the method and the battery system will be explained wherein details/embodiments described with respect to the method also apply to the battery system and vice versa.

The first electronic component and/or the second electronic component may be electronic components of the battery system that are adapted for monitoring the battery cells of the battery system. For example, the first electronic component may be a control unit adapted to perform the functions of a battery management system, BMS, as explained introductorily, and the second electronic component may be the battery pack including the battery cells. Of course, it may also be the other way around.

The first and second electronic components are electrically interconnected via the method, i.e. an electrical connection between the first and second electronic components is established. When this electrical connection is established, the first and/or second electronic components can perform their intended functions. For example, the BMS may then monitor the battery cells, for example a state, charging status or a temperature of the battery cells as explained above.

The first electronic component according to the present disclosure includes a flexible printed circuit (FPC). The FPC may be a flexible printed circuit board (FPCB). The FPC includes at least one connection portion, wherein on a surface of the connection portion at least one conductive strip is disposed. Multiple conductive strips may be disposed on the surface of the connection portion. The connection portion is an intrinsic part of the FPC rather than a separate element. The connection portion may be a part of a substrate forming the FPC, or in other words of the board forming the FPCB. The conductive strips may be free endings of conductive paths/tracks of the FPC. In a first state, the connection portion and thus the conductive strips are flat, meaning that they extend along a plane/flat surface. In a second state, the connection portion and thus the conductive strips are folded (or bent), for example to a U-shape, so that they no longer extend along a plane/flat surface. In the second state, i.e. when folded, the connection portion and conductive strips form one or more pins where the conductive strips are disposed on an outer surface of the folded connection portion. The FPC may include multiple such pins separated by slots in the FPC, wherein each pin may include one conductive strip as explained in more detail below.

The second electronic component according to the present disclosure includes a printed circuit board (PCB). The PCB may be a rigid (i.e. non-flexible) PCB. The PCB includes at least one through-hole that is adapted to receive the at least one pin of the FPC. The PCB may include multiple through-holes wherein each of the through-holes may be adapted to receive one of the pins of the FPC. The through-holes may be arranged in one or more rows. The one or more through-holes of the PCB extend through the PCB from a first side of the PCB to a second side of the PCB thus each forming a passage through the PCB. At the second side of the PCB electrically conductive platings are disposed adjacent to each of the through-holes. The conductive platings may be metal platings.

To establish the electrical interconnection between first and second electronic components, the FPC of the first electronic component is electrically connected to the PCB of the second electronic component. This may be achieved via the method of the present disclosure.

In a first step of the method of the present disclosure, the FPC and the PCB are attached to one another such that each of the pins of the FPC is received by one of the through-holes of the PCB. In other words, the pins of the FPC are inserted into the corresponding through-holes of the PCB. When the FPC is attached to the PCB, the pins may extend through the respective through-hole from the first side to the second side such that a tip of each of the pins protrudes above the second side of the PCB. As explained, the conductive strips of the pins are not separate elements but an intrinsic part of the FPC, namely free endings of conductive paths/tracks of the FPC. Thus, in the first step the FPC is, with its pins, directly inserted into the PCB without the need for a separate connector such as a plug connector. Rather, the connection portion with the conductive strips is folded, or pre-folded during manufacture of the FPC, so that the pins and thus an intrinsic or one-piece connector is formed for connecting to the PCB. In other words, the pins are formed by bending a part of the FPC.

In a second step of the method of the present disclosure, which follows the first step, each of the pins of the FPC is soldered to the respective conductive plating of the PCB at the second side of the PCB. Thus, for each pin, an electrical connection is established between the conductive strip extending along the outer surface of the folded pin and the adjacent conductive plating. For example, a tip of the respective pin extending above the second side of the PCB may be soldered to the PCB in that the solder electrically connects the conductive strip of the pin of the FPC to the conductive plating of the PCB. As a result, the FPC and the PCB, and therefore the first electronic component and the second electronic component, are electrically connected to one another. Thus, at each of the through-holes an electrically conductive plating may be disposed at the second side of the PCB adjacent to the respective through-hole.

The electrical connection between the first electronic component and the second electronic component is achieved quickly because the FPC merely is inserted with its pins into the corresponding through-holes of the PCB and the pins are soldered. No additional part, such as a plug connector, is needed. Rather, the connections portion with its pins forms an intrinsic or one-piece connector with the FPC. Further, the pins and their electrical connection to the PCB can be easily visually inspected to ensure the connection is correctly/sufficiently achieved. The soldering step is simplified because the pins are not merely placed on the platings but are, due to the through-holes, precisely arranged relative to the platings. Thus, the soldering may be performed quicker and with fewer or no errors. The electrical connection achieved via the method and battery system of the present disclosure is therefore low-cost, fast and reliable.

According to an embodiment, the method further includes the step of: folding, before the attaching of the FPC to the PCB, the connection portion, with the one or more conductive strips extending along its surface, to a U-shape such that the one or more conductive strips extend along the outer surface of the resulting U-shaped connection portion, the U-shaped connection portion with the one or more conductive strips thus forming the one or more pins. In other words, the FPC may include the one or more conductive strips on a surface of the connection portion, wherein the method may include: folding the connection portion of the FPC to a U-shape such that the conductive strips extend along the outer surface of the resulting U-shaped connection portion, wherein the U-shaped connection portion with the one or more conductive strips forms the one or more pins. Thus, the above-explained folding of the connection portion may form part of the method of the present disclosure. This folding of the connection portion allows for forming the pins as an intrinsic/one-piece element of the FPC and therefore provides a simple and effective way of configuring/forming the pins and the connection to the PCB. No separate connector, such as a plug connector, is needed for electrically connecting the FPC and the PCB.

According to an embodiment, the soldering includes selective wave soldering. Selective wave soldering may provide for a simple and reliable connection between the conductive strips of the pins and the conductive platings of the PCB. Such a soldering is one of the most low-cost, fast and reliable soldering methods, e.g. when compared to hot bar soldering.

According to an embodiment, the connection portion includes multiple connection arms, wherein on the surface of each of the connection arms one of the conductive strips is disposed, the connection arms being separated from one another via slots in the FPC, wherein each of the connection arms with its conductive strip forms one of the pins. In other words, the connection portions may include multiple connections arms, wherein neighboring connection arms are spaced apart from each other via a slot in the FPC (for example in the substrate/board of the FPC). Along each of the connection arms one of the conductive strips of the FPC extends. During the folding of the connection portion, each of the connection arms is folded to a U-shape as well such that the conductive strip of the respective connection arm extends along the outer surface of the resulting U-shaped connection arm. Each of the connection arms forms in the folded position, i.e. when U-shaped, one of the pins with its conductive stripe extending along the outer surface of the U-shaped connection arm and thus of the pin. According to an embodiment, the PCB includes multiple of the through-holes, the number of the through-holes corresponding to the number of pins. The through-holes of the PCB may be spaced apart from each other by the same distance the connection arms, and therefore the pins, are spaced apart from one another. When attaching the FPC to the PCB, each of the pins of the FPC may then be received by one of the through-holes of the PCB. This embodiment may allow for a simple connection between the FPC and the PCB. The separation of the pins may ensure that, when soldering a pin to the respective conductive plating, an electrical connection is made only between said pin and conductive plating and not mistakenly between neighboring pins/platings.

According to an embodiment, the connection portion of the FPC includes a first connection portion extending from a first end of the FPC and a second connection portion extending from a second end of the FPC opposite the first end, wherein one or more first pins of the one or more pins are formed by folding the first connection portion to a U-shape, one or more first conductive strips of the one or more conductive strips being disposed on a surface of the first connection portion along the outer surface of the U-shaped first connection portion, and wherein one or more second pins of the one or more pins are formed by folding the second connection portion to a U-shape, one or more second conductive strips of the one or more conductive strips being disposed on a surface of the second connection portion along the outer surface of the U-shaped second connection portion. In other words, the FPC may include more than one connection portion wherein each of the connection portions may form at least one pin. The connection portions may include multiple connection arms as explained above so that each connection portion may form multiple pins. For example, a first number of pins of the one or more pins may be formed by folding the first connection portion with the connection arms to a U-shape such that one conductive strip extends along the outer surface of each of the U-shaped connection arms/pins. The FPC may include a third connection portion extending from a third end of the FPC, the third end arranged between the first end and the second end. Correspondingly, the PCB may include one or more first through-holes of the one or more through-holes at a first end of the PCB and one or more second through-holes of the one or more through-holes at a second end of the PCB. The first through-hole may be adapted to receive the first pin and the second through-hole may be adapted to receive the second pin.

According to this embodiment, the FPC and the PCB are interconnected via pins of multiple connection portions at different positions/ends of the FPC and PCB. When attaching the FPC to the PCB, the first pins and first through-holes and the second pins and second through-holes are aligned and connected as explained above. The FPC and the PCB may thus need to be aligned to each other, for example in a mistake-proof ("poka-yoke") manner. This ensures the correct connection between the FPC and the PCB. The pins and through-holes of the present disclosure allow a low-cost, fast and reliable connection between the electronic components also for such a battery system.

According to an embodiment, the attaching of the FPC and the PCB includes adhering the FPC and PCB together before soldering. In that regard, the FPC may include an adhesive at its surface, i.e. at the side of the FPC that faces the PCB. Alternatively or additionally, the PCB may include an adhesive at its first side, i.e. at the side of the PCB that faces the FPC. Such an adhesive may e.g. include double-sided tape and/or glue. Via the adhesive the FPC and PCB may be securely attached to one another before the soldering step which eases the soldering.

According to an embodiment, a battery system is provided including a plurality of battery cells, a first electronic component includes a flexible printed circuit, FPC, the FPC including one or more pins formed by folding a connection portion of the FPC, and a second electronic component electrically connected to the first electronic component, wherein the second electronic component includes a printed circuit board, PCB having one or more through-holes each adapted to receive one of the pins of the FPC, and wherein the connection portion has at least one slot located between the pins. As mentioned above, the above explanations may also pertain to the battery system.

According to an embodiment, the connection portion comprises multiple connection arms separated from one another via the at least one slot. According to further embodiment, the connection portion further comprises an end face portion keeping or forming a bridge between the connection arms at a free end of the connection portion. As mentioned above, multiple connection portions may be provided wherein each connection portion may include multiple connection arms. Thus, each of the connection portion may include multiple connection arms having a conductive strip thereon. Neighboring connection arms may be separated from one another via slots formed between the connection arms. When forming the slots, an end face portion for each of the connection portions may remain. The end face portion may give stability to the connection portions as it keeps or forms a bridge between the connection arms at a free end of the connection portion.

According to an embodiment of the battery system, one or more conductive strips are disposed on an outer surface of the connection portion. Further details of the conductive strips are discussed above.

According to an embodiment of the battery system, at each of the through-holes an electrically conductive plating is disposed at a side of the PCB adjacent to the through-hole. Each of the pins of the FPC may be soldered to the respective electrically conductive plating of the PCB at the side of the PCB. Further details of the conductive plating are discussed above.

An aspect of the present disclosure pertains to an electric vehicle including a battery system as explained above, i.e. a battery system provided by the method explained above.

### Specific Embodiments

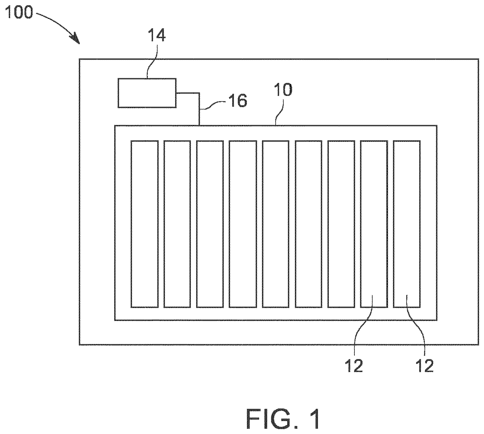

Fig. 1 schematically illustrates a battery system 100 according to an embodiment, the battery system 100 including a battery pack 10 with a plurality of battery cells 12. The battery cells 12 are monitored by a control unit 14 which realizes functions of a battery management system, BMS. The control unit 14 and the battery pack 10 are electrically interconnected via an electrical connection 16.

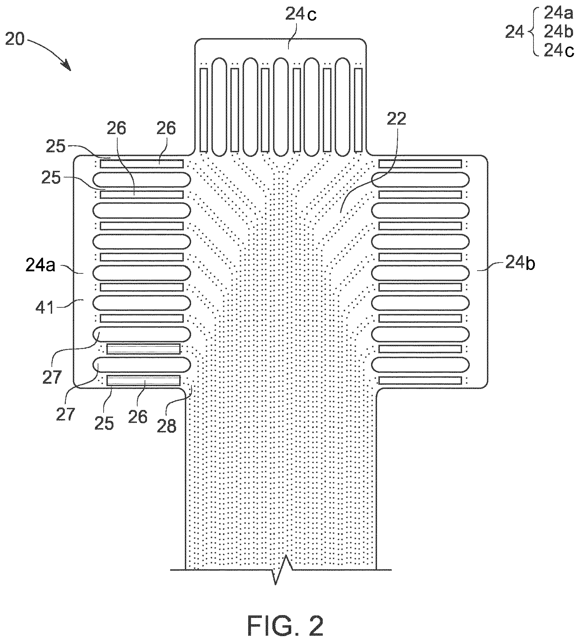

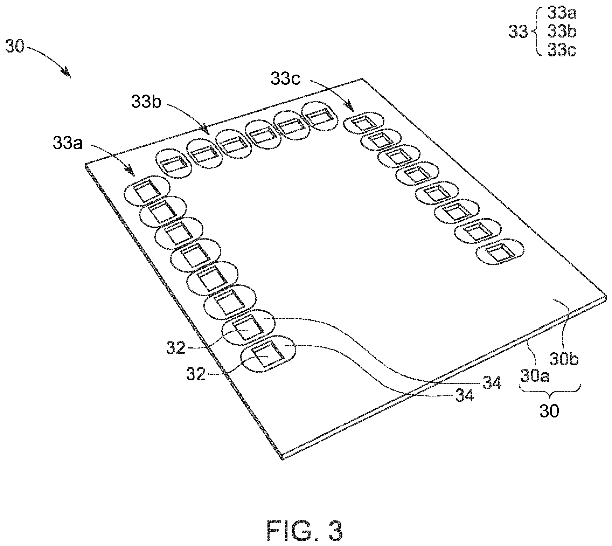

The electrical connection 16 is established by connecting a flexible printed circuit, FPC, 20 (see Fig. 2) of the control unit 14 to a rigid printed circuit board, PCB, 30 (see Fig. 3) of the battery pack 10. Alternatively, the electrical connection 16 may be established by connecting an FPC of the battery pack 10 to a PCB of the control unit 14.

As shown in Fig. 2, the FPC 20 includes a central portion 22 and three connection portions 24, namely a first connection portion 24a, a second connection portion 24b, and a third connection portion 24c. The connection portions 24 extend from the central portion 22 at different sides or ends of the central portion 22. The first connection portion 24a extends from a first end of the FPC 20 and the second connection portion 24b extends from a second end of the FPC 20 opposite the first end. The third connection portion 24c extends from a third end of the FPC 20, the third end being arranged between the first end and the second end.

Each of the connection portions 24 includes multiple connection arms 25 having a conductive strip 26 thereon. Neighboring connection arms 25 are separated from one another via slots 27 formed between the connection arms 25. When forming the slots 27, an end face portion 41 for each of the connection portions 24 remains. The end face portion 41 may give stability to the connection portions 24 as it keeps or forms a bridge between the connection arms 25 at a free end of the connection portion 24. The conductive strips 26 are endings of conductive paths/tracks 28 of the FPC 20, see Fig. 2.

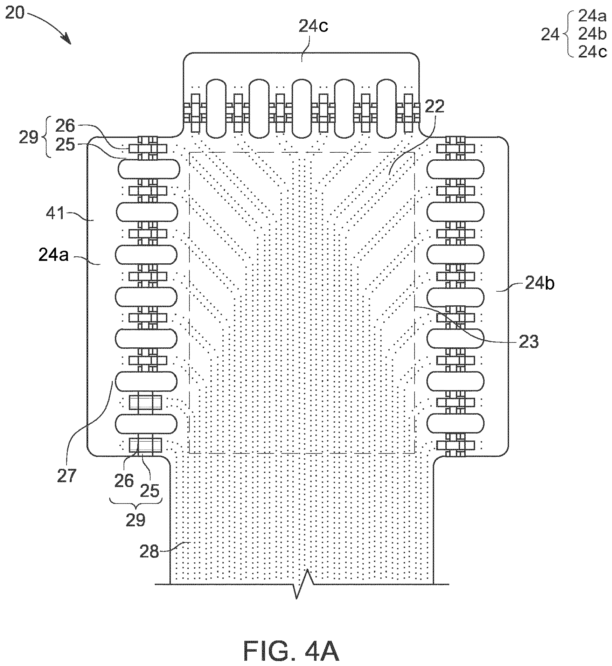

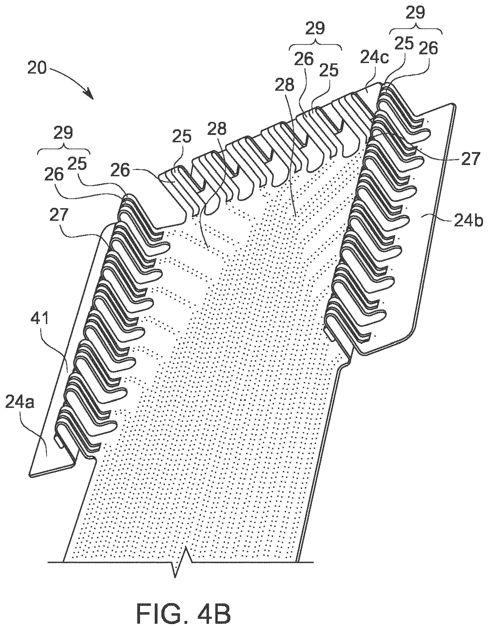

In Fig. 2, the connection portions 24 are shown in a first state where the conductive strips are 24 extend along a plane or flat surface, i.e. along the plane the central portion 22 extends. According to an embodiment, the connection portions 24 and thus their connection arms 25 with the conductive strips 26 are, in a second state, folded to protrude, for example, into a U-shape. This is shown in Fig. 4a and 4b. In the second state, i.e. when folded, each of the U-shaped connection arms 25 forms, together with its conductive strip 26, a pin 29 where the conductive strip 26 is disposed on an outer surface of the U-shaped connection arm 25 or pin 29. It can be seen e.g. in Fig. 4b that the pins 29 extend above an upper surface of the FPC 20. The connection portions 24 can be folded as such during manufacture of the FPC 20, or during assembly of the FPC 20 and PCB 30 before attaching the FPC 20 to the PCB 30. When the connection arms 25, together with its conductive strips 26, are folded into a U-shape, the connection arms 25 can be easily folded by the slots 27 arranged between the connection arms 25, i.e. between the pins 29.

Fig. 3 shows the PCB 30. The PCB 30 including multiples rows 33 of through-holes 32. A first row 33a includes a number of through-holes 32 corresponding to the number of pins 29 of the first connection portion 24a, a second row 33b includes a number of through-holes 32 corresponding to the number of pins 29 of the second connection portion 24b, and a third row 33a includes a number of through-holes 32 corresponding to the number of pins 29 of the third connection portion 24c. The through-holes 32 are each adapted to receive one of the pins 29 of the FPC 20, the through-holes 32 extending through the PCB 30 from a first side 30a of the PCB 30, which is the bottom side in Fig. 3, to a second side 30b of the PCB 30, which is the top side in Fig. 3. At the second side 30b, each of the through-holes 32 is surrounded by an electrically conductive plating 34. However, this is not limited thereto, the first side of the PCB 30 can be the top side in Fig. 3 and the second side of the PCB 30 can be the bottom side in Fig. 3 because the first side of the PCB 30 is the opposite of the second side of the PCB 30.

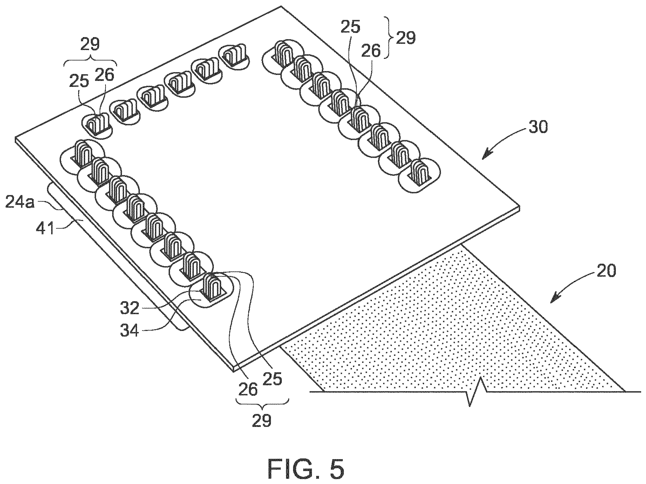

When connecting the FPC 20 to the PCB 30, the FPC 20 is attached to the first side 30a of the PCB 30 such that each of the pins 29 of the FPC 20 is received by one of the through-holes 29 of the PCB as shown in Fig. 5. In this attached state, each of the pins 29 extends through its respective through-hole 32 such that a tip of the pin 29 extends above the second side 30b of the PCB 30. To securely attach the FPC 20 to the first side 30a of the PCB 30, the upper surface of the FPC 20 and/or the first side 30a of the PCB 30 is provided with an adhesive area 23. Thus, the FPC 20 may stick to the PCB 30. Although not shown in Fig. 5, a conductive plating 34 may be provided for every through-hole 32 of the PCB 30 as shown in Fig. 3.

After the attaching, each of the pins 29 of the FPC 20 is soldered to the respective conductive plating 34 of the PCB 30 at the second side 30b of the PCB 30. For example, the soldering may be selective wave soldering. Thereby the FPC 20 and PCB 30, and as a result the control unit 14 and the battery pack 10, are electrically interconnected.

The electrical connection between the control unit 14 and the battery pack 10 is thus achieved in a simple, reliable and quick manner. The FPC 20 merely needs to be inserted with its pins 29, after the connection portions 24 have been folded, into the corresponding through-holes 32 of the PCB 30 and the pins 29 soldered. No additional part, such as a plug connector, is needed. Rather, the connections portions 24 with their pins 29 form an intrinsic or one-piece connector with the FPC 20. The pins 29 and their electrical connection to the PCB 30, i.e. the soldering between the conductive strips 26 and the conductive plating 34, can be easily visually inspected by a person to ensure the connection is correctly/sufficiently achieved. Due to the connection portions 24 being arranged at different endings of the FPC 20 and the rows 33 of through-holes 32 being arranged at corresponding endings of the PCB 30, the FPC 20 and the PCB 30 can only be attached to one another in one possible alignment which makes the assembly mistake-proof. As the pins 29 are precisely placed in their corresponding through-holes 32, the subsequent soldering is simplified. Thus, the soldering may be performed quicker and with fewer or no errors.

### Reference signs

- 10: battery pack
- 12: battery cells
- 14: control unit
- 16: electrical connection
- 20: FPC
- 22: central portion of FPC
- 23: adhesive area
- 24: connection portions
- 24a: first connection portion
- 24b: second connection portion
- 24c: third connection portion
- 25: connection arms
- 26: conductive strips
- 27: slots
- 28: conductive paths/tracks
- 30: PCB
- 32: through-holes
- 33: row of through-holes
- 34: conductive platings
- 41: end face portion
- 100: battery system

## Claims

1. A method for electrically connecting a first electronic component (14) of a battery system (100) with a second electronic component (10) of the battery system (100), the first electronic component (14) having a flexible printed circuit, FPC, (20) wherein the FPC (20) comprises one or more pins (29) formed by folding a connection portion (24) of the FPC (20), one or more conductive strips (26) being disposed on an outer surface of the folded connection portion (24), the second electronic (10) component having a printed circuit board, PCB, (30) wherein the PCB (30) comprises one or more through-holes (32) each adapted to receive one of the pins (29) of the FPC (20), the through-holes (32) extending through the PCB (30) from a first side of the PCB (30) to a second side of the PCB (30), wherein at each of the through-holes (32) an electrically conductive plating (34) is disposed at the second side of the PCB (30) adjacent to the through-hole (32), the method comprising the steps of:
a) attaching the FPC (20) to the first side of the PCB (30) such that each of the pins (29) of the FPC (20) is received by one of the through-holes (32) of the PCB (30),
b) soldering each of the pins (29) of the FPC (20) to the respective conductive plating (34) of the PCB (30) at the second side of the PCB (30) to electrically interconnect the FPC (20) and the PCB (30).

2. The method of claim 1, further comprising: folding, before the attaching of the FPC (20) to the PCB (30), the connection portion (24), with the one or more conductive strips (26) extending along its surface, to a U-shape such that the one or more conductive strips (26) extend along the outer surface of the resulting U-shaped connection portion (24), the U-shaped connection portion (24) with the one or more conductive strips (26) thus forming the one or more pins (29).

3. The method of claim 1 or 2, wherein the soldering comprises selective wave soldering.

4. The method of any one of the preceding claims, wherein the connection portion (24) comprises multiple connection arms (25), wherein on a surface of each of the connection arms (25) one of the conductive strips (26) is disposed, the connection arms (25) being separated from one another via slots (27) in the FPC (20), wherein each of the connection arms (25) with its conductive strip (26) forms one of the pins (29).

5. The method of any one of the preceding claims, wherein the connection portion (24) of the FPC (20) comprises a first connection portion (24a) extending from a first end of the FPC (20) and a second connection portion (24b) extending from a second end of the FPC (20) opposite the first end, wherein one or more first pins (29) of the one or more pins are formed by folding the first connection portion (24a) to a U-shape, one or more first conductive strips (26) of the one or more conductive strips being disposed on a surface of the first connection portion (24a) along the outer surface of the U-shaped first connection portion (24a), and wherein one or more second pins (29) of the one or more pins are formed by folding the second connection portion (24b) to a U-shape, one or more second conductive strips (26) of the one or more conductive strips being disposed on a surface of the second connection portion (24b) along the outer surface of the U-shaped second connection portion (24b).

6. The method of any one of the preceding claims, wherein the joining of the FPC (20) and the PCB (30) comprises adhering the FPC (20) and PCB (30) together before soldering.

7. A battery system (100) comprising:
a plurality of battery cells (12);
a first electronic component (14) comprising a flexible printed circuit, FPC, (20) the FPC (20) comprising one or more pins (29) formed by folding a connection portion (24) of the FPC (20), and
a second electronic component (10) electrically connected to the first electronic component (14),
wherein the second electronic component (10) comprises a printed circuit board, PCB, (30) the PCB (30) having one or more through-holes (32) each adapted to receive one of the pins (29) of the FPC (20), and
wherein the connection portion (24) has at least one slot (27) located between the pins (29).

8. The battery system (100) according to claim 7, wherein the connection portion (24) comprises multiple connection arms (25) separated from one another via the at least one slot (27).

9. The battery system (100) according to claim 8, wherein the connection portion (24) further comprises an end face portion (41) keeping or forming a bridge between the connection arms (25) at a free end of the connection portion (24).

10. The battery system (100) according to one of claims 7 to 9, wherein one or more conductive strips (26) are disposed on an outer surface of the connection portion (24).

11. The battery system (100) according to one of claims 7 to 10, wherein at each of the through-holes (32) an electrically conductive plating (34) is disposed at a side of the PCB (30) adjacent to the through-hole (32).

12. The battery system (100) according to claim 11, wherein the each of the pins (29) of the FPC (20) is soldered to the respective electrically conductive plating (34) of the PCB (20) at the side of the PCB (20).

13. An electric vehicle comprising the battery system (100) according to any one of claims 7 to 12.

## Amended claims

### Amended claims in accordance with Rule 137(2) EPC.

1. A method for electrically connecting a first electronic component (14) of a battery system (100) with a second electronic component (10) of the battery system (100), the first electronic component (14) having a flexible printed circuit, FPC, (20) wherein the FPC (20) comprises multiple pins (29) formed by folding a connection portion (24) of the FPC (20), multiple conductive strips (26) being disposed on an outer surface of the folded connection portion (24), the second electronic (10) component having a printed circuit board, PCB, (30) wherein the PCB (30) comprises multiple through-holes (32) each adapted to receive one of the pins (29) of the FPC (20), the through-holes (32) extending through the PCB (30) from a first side of the PCB (30) to a second side of the PCB (30), wherein at each of the through-holes (32) an electrically conductive plating (34) is disposed at the second side of the PCB (30) adjacent to the through-hole (32), and wherein the connection portion (24) further comprises an end face portion (41) keeping or forming a bridge between the connection arms (25) at a free end of the connection portion (24), the method comprising the steps of:
a) attaching the FPC (20) to the first side of the PCB (30) such that each of the pins (29) of the FPC (20) is received by one of the through-holes (32) of the PCB (30),
b) soldering each of the pins (29) of the FPC (20) to the respective conductive plating (34) of the PCB (30) at the second side of the PCB (30) to electrically interconnect the FPC (20) and the PCB (30).

2. The method of claim 1, further comprising: folding, before the attaching of the FPC (20) to the PCB (30), the connection portion (24), with the one or more conductive strips (26) extending along its surface, to a U-shape such that the one or more conductive strips (26) extend along the outer surface of the resulting U-shaped connection portion (24), the U-shaped connection portion (24) with the one or more conductive strips (26) thus forming the one or more pins (29).

3. The method of claim 1 or 2, wherein the soldering comprises selective wave soldering.

4. The method of any one of the preceding claims, wherein the connection portion (24) comprises multiple connection arms (25), wherein on a surface of each of the connection arms (25) one of the conductive strips (26) is disposed, the connection arms (25) being separated from one another via slots (27) in the FPC (20), wherein each of the connection arms (25) with its conductive strip (26) forms one of the pins (29).

5. The method of any one of the preceding claims, wherein the connection portion (24) of the FPC (20) comprises a first connection portion (24a) extending from a first end of the FPC (20) and a second connection portion (24b) extending from a second end of the FPC (20) opposite the first end, wherein one or more first pins (29) of the one or more pins are formed by folding the first connection portion (24a) to a U-shape, one or more first conductive strips (26) of the one or more conductive strips being disposed on a surface of the first connection portion (24a) along the outer surface of the U-shaped first connection portion (24a), and wherein one or more second pins (29) of the one or more pins are formed by folding the second connection portion (24b) to a U-shape, one or more second conductive strips (26) of the one or more conductive strips being disposed on a surface of the second connection portion (24b) along the outer surface of the U-shaped second connection portion (24b).

6. The method of any one of the preceding claims, wherein the joining of the FPC (20) and the PCB (30) comprises adhering the FPC (20) and PCB (30) together before soldering.

7. A battery system (100) comprising:
a plurality of battery cells (12);
a first electronic component (14) comprising a flexible printed circuit, FPC, (20) the FPC (20) comprising multiple pins (29) formed by folding a connection portion (24) of the FPC (20), and
a second electronic component (10) electrically connected to the first electronic component (14),
wherein the second electronic component (10) comprises a printed circuit board, PCB, (30) the PCB (30) having multiple through-holes (32) each adapted to receive one of the pins (29) of the FPC (20),
wherein the connection portion (24) has at least one slot (27) located between the pins (29), and
wherein the connection portion (24) further comprises an end face portion (41) keeping or forming a bridge between the connection arms (25) at a free end of the connection portion (24).

8. The battery system (100) according to claim 7, wherein the connection portion (24) comprises multiple connection arms (25) separated from one another via the at least one slot (27).

9. The battery system (100) according to one of claims 7 to 8, wherein one or more conductive strips (26) are disposed on an outer surface of the connection portion (24).

10. The battery system (100) according to one of claims 7 to 9, wherein at each of the through-holes (32) an electrically conductive plating (34) is disposed at a side of the PCB (30) adjacent to the through-hole (32).

11. The battery system (100) according to claim 10, wherein the each of the pins (29) of the FPC (20) is soldered to the respective electrically conductive plating (34) of the PCB (20) at the side of the PCB (20).

12. An electric vehicle comprising the battery system (100) according to any one of claims 7 to 11.
